Europäisches Patentamt

European Patent Office

Office européen des brevets

(19)

(11) **EP 1 130 788 A2**

(12) **EUROPÄISCHE PATENTANMELDUNG**

(43) Veröffentlichungstag:
**05.09.2001 Patentblatt 2001/36**

(51) Int Cl.⁷: **H03M 13/41**

(21) Anmeldenummer: **01105112.5**

(22) Anmeldetag: **02.03.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **02.03.2000 DE 10010238**

(71) Anmelder: **Infineon Technologies AG**
**81669 München (DE)**

(72) Erfinder: **Traeber, Mario**
**81539 München (DE)**

(74) Vertreter: **Barth, Stephan Manuel, Dr.**
**Reinhard-Skuhra-Weise & Partner Gbr,**
**Patentanwälte**
**Friedrichstrasse 31**
**80801 München (DE)**

(54) **Verfahren zum Speichern von Pfadmetriken in einem Viterbi-Decodierer**

(57) Für einen Viterbi-Decodierer wird vorgeschlagen, die Butterfly-Strukturen des entsprechenden Trellis-Diagramms derart paarweise zusammenzufassen, daß für jedes Butterfly-Strukturenpaar die Zielzustände der beiden Butterfly-Strukturen in dem Trellis-Diagramm zugleich Ausgangszustände für zwei andere Butterfly-Strukturen bilden. Nach der Bestimmung der Pfadmetriken der Zielzustände der beiden Butterfly-Strukturen eines Butterfly-Strukturenpaars werden dann jeweils die Pfadmetriken derjenigen beiden Zielzustände dieses Butterfly-Strukturenpaares, die zugleich Ausgangszustände einer anderen Butterfly-Struktur bilden, in Form eines gemeinsamen Speicherworts gespeichert.

FIG 1

idendische Trellis-Zustände

**Beschreibung**

Die vorliegende Erfindung betrifft ein Verfahren zum Speichern von Pfadmetriken in einem Viterbi-Decodierer nach dem Oberbegriff des Anspruches 1, wobei das Verfahren insbesondere für Viterbi-Decodierer in Mobilfunkempfängern zur Decodierung von kanalcodierten Mobilfunksignalen einsetzbar ist.

Solch ein Verfahren ist aus der Wo 00/08768 bekannt, welche einen Viterbi-Decoder mit einem größenreduzierten Pfadmetrikspeicher offenbart.

Auch aus der US-A-5,327,440 ist ein Verfahren zum effektiven Speichern von Pfadmetriken in einem Viterbi-Decoder der gattungsgemäßen Art offenbart.

In den meisten bekannten digitalen Mobilfunkempfängern wird ein Viterbi-Decodierer verwendet. Ein Viterbi-Decodierer ist ein sogenannter Maximum-Likelihood-Decodierer, der in der Regel zur Decodierung von kanalcodierten, insbesondere faltungscodierten Mobilfunksignalen verwendet wird. Bei der Kanalcodierung wird im Sender den zu übertragenden Symbolen redundante Information hinzugefügt, um die Übertragungssicherheit zu erhöhen. Bei der Übertragung eines Mobilfunksignals wird dieses jedoch von Rauschen überlagert. Die Aufgabe des Empfängers besteht daher darin, anhand der Empfangssequenz aus sämtlichen möglichen Sendesequenzen diejenige Sendesequenz herauszufinden, die mit größtmöglicher Wahrscheinlichkeit der tatsächlichen Sendesequenz entspricht. Diese Aufgabe wird von dem Viterbi-Decodierer wahrgenommen.

Die bei der Kanalcodierung verwendete Codiervorschrift kann durch ein entsprechendes Trellis-Diagramm beschrieben werden. Der Viterbi-Decodierer ermittelt durch Berechnung sogenannter Metriken denjenigen Pfad des Trellis-Diagramms, der abhängig von der jeweiligen Ausgestaltung des Decodierers die größte oder kleinste Pfadmetrik besitzt. Anhand dieses Pfads des Trellis-Diagramms kann dann die decodierte Sequenz bestimmt und ausgegeben werden.

Nachfolgend sollen kurz die Grundlagen der Viterbi-Decodierung näher erläutert werden.

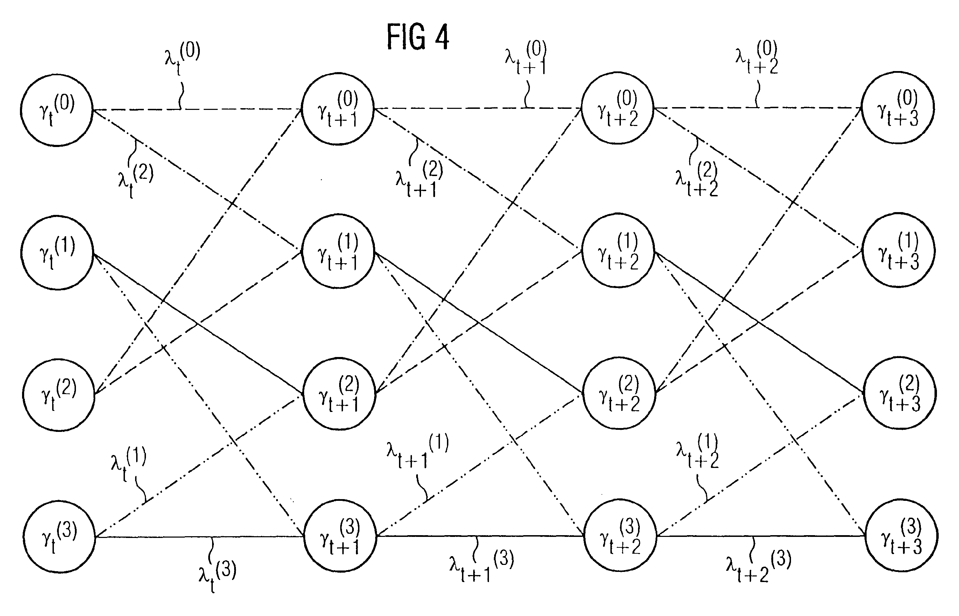

In Fig. 4 ist beispielhaft ein Trellis-Diagramm mit jeweils vier unterschiedlichen Zuständen zu den Zeitpunkten t...t+3 dargestellt, die beispielsweise den Bitzuständen '00', '10', '01' und '11' entsprechen. Jeder Symbolsequenz ist in dem Trellis-Diagramm ein entsprechender Pfad zugeordnet. Ein Pfad umfaßt dabei eine Folge von Zweigen zwischen zwei zeitlich aufeinderfolgenden Zuständen. Jeder Zweig symbolisiert dabei einen Zustandsübergang zwischen zwei zeitlich aufeinanderfolgenden Zuständen, wobei beispielsweise der von einem Zustand ausgehende obere Zweig einem Empfangssymbol mit dem binären '0' und der von demselben Zustand ausgehende untere Zweig einem Empfangssymbol mit dem binären Wert '1' entspricht. Jeder dieser Zustandsübergänge, dem eine Zweigmetrik ('Branch Metrik', BM) $\lambda_t$ zugewiesen ist, entspricht einem Sendesymbol. Die Zweigmetrik $\lambda_t$ ist wie folgt definiert:

$$\lambda_t = \left| y'_t - r_t^2 \right|$$

Dabei entspricht $r_t$ dem Empfangssymbol zum Zeitpunkt t und $y'_t$ dem davon abhängig erwarteten Sendesymbol zum Zeitpunkt t.

Darüber hinaus ist jedem Pfad durch das Trellis-Diagramm bis zum Zeitpunkt bzw. Zeitschritt t eine Pfadmetrik $\gamma_t$ zugewiesen.

Bei dem in Fig. 4 gezeigten Trellis-Diagramm handelt es sich insbesondere um ein Trellis-Diagramm mit einer sogenannten 'Butterfly'-Struktur. Dies bedeutet, daß jeweils zwei Zuständen eines Zeitschritts t+1 des Trellis-Diagramms zwei Zustände des vorhergehenden Zeitschritts t zugewiesen sind, deren Zweige jeweils zu den erstgenannten Zuständen des Zeitschritts t+1 führen, wobei jeweils zwei Zweigmetriken der von unterschiedlichen Zuständen ausgehenden Zweige identisch sind. So bilden beispielsweise die in Fig. 4 gezeigten Zustände, denen die Pfadmetriken $\gamma_t^{(1)}$, $\gamma_t^{(3)}$, $\gamma_{t+1}^{(2)}$ und $\gamma_{t+1}^{(3)}$ zugewiesen sind, eine derartige 'Butterfly'-Struktur, wobei die Zweigmetrik für den Zweig von dem Zustand mit der Pfadmetrik $\gamma_t^{(1)}$ zu dem Zustand mit der Pfadmetrik $\gamma_{t+1}^{(2)}$ der Zweigmetrik $\lambda_t^{(3)}$ des Zweigs von dem Zustand mit der Pfadmetrik $\gamma_t^{(3)}$ zu dem Zustand mit der Pfadmetrik $\gamma_{t+1}^{(3)}$ entspricht, während andererseits die Zweigmetrik des Zweigs von dem Zustand mit der Pfadmetrik $\gamma_t^{(1)}$ zu dem Zustand mit der Pfadmetrik $\gamma_{t+1}^{(3)}$ der Zweigmetrik $\lambda_t^{(1)}$ des Zweigs von dem Zustand mit der Pfadmetrik $\gamma_t^{(3)}$ zu dem Zustand mit der Pfadmetrik $\gamma_{t+1}^{(2)}$ entspricht. Dabei bezeichnet allgemein $\gamma_t^{(s)}$ die dem Zustand s im Zeitschritt t zugewiesene Pfadmetrik, während $\lambda_t^{(s)}$ die Zweigmetrik des dem Signal s entsprechenden Zustandsübergang zum Zeitpunkt t bezeichnet.

Der Viterbi-Decodierer muß nunmehr anhand eines dem Trellis-Diagramm entsprechenden Algorithmus denjenigen Pfad ermitteln, der die beste Pfadmetrik aufweist. In der Regel ist dies definitionsgemäß der Pfad mit der kleinsten Pfadmetrik.

Jede Pfadmetrik eines zu einem bestimmten Zustand führenden Pfads setzt sich aus der Pfadmetrik eines zeitlich vorhergehenden Zustands und der Zweigmetrik des von diesem vorhergehenden Zustand zu dem bestimmten Zustand führenden Zweigs zusammen. Dies hat zur Folge, daß nicht alle möglichen Pfade und Pfadmetriken des Trellis-Diagramms ermittelt und ausgewertet werden müssen. Statt dessen wird für jeden Zustand und für jeden Zeitschritt des Trellis-Diagramms jeweils derjenige Pfad ermittelt, der bis zu diesem Zeitpunkt die beste Pfadmetrik aufweist. Nur dieser als 'Survivor Path' bezeichnete Pfad und seine Pfadmetrik muß gespeichert werden. Alle anderen zu diesem Zustand führenden Pfade können unberücksichtigt bleiben. Während jedes Zeitschritts gibt es demnach eine der Anzahl der unterschiedlichen Zustände entsprechende Anzahl an derartigen 'Survivor Paths'.

Die obige Beschreibung macht deutlich, daß die Berechnung der Pfadmetrik $\gamma_{t+1}^{(s)}$ von den Pfadmetriken der mit dem Zustand s über einen Zweig verbundenen Pfadmetriken des vorhergehenden Zeitschritts t abhängt. Die Berechnung der Pfadmetriken kann demnach durch einen rekursiven Algorithmus realisiert werden, der in einem Viterbi-Decodierer von einer sogenannten 'Add-Compare-Select'-Einheit (ACS-Einheit) wahrgenommen wird.

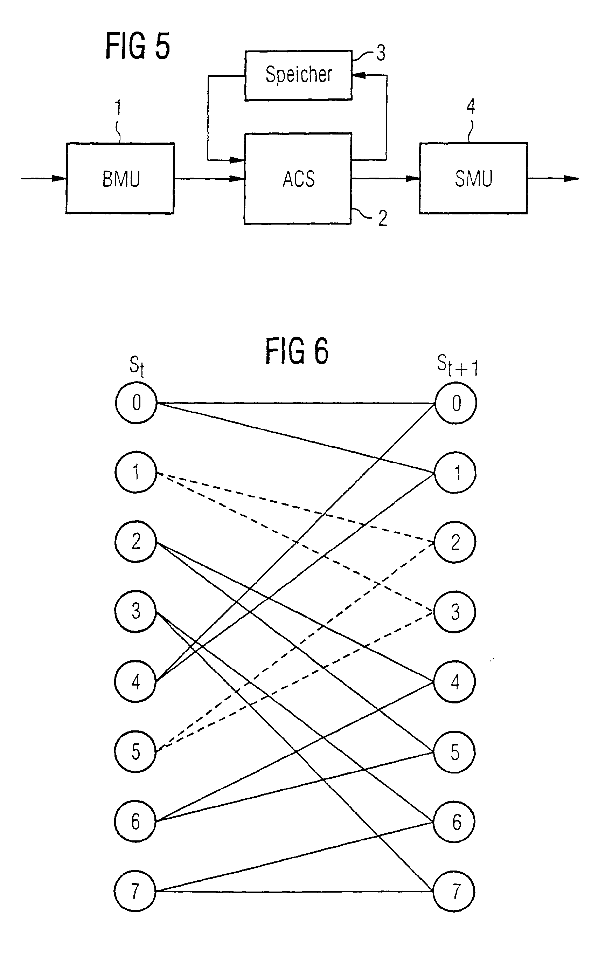

In Fig. 5 ist der typische Aufbau eines Viterbi-Decodierers dargestellt.

Neben der ACS-Einheit 2 mit einem Speicher oder Register 3 sind eine 'Branch Metric Unit' (BMU) 1 und eine 'Survivor Memory Unit' 4 vorgesehen. Die Aufgabe der 'Branch Metric Unit' ist die Berechnung der Zweigmetriken $\lambda_t^{(s)}$, die ein Maß für den Unterschied zwischen einem Empfangssymbol und demjenigen Symbol, welches in dem Trellis-Diagramm den entsprechenden Zustandsübergang hervorruft, sind. Die von der 'Branch Metric Unit' 1 berechneten Zweigmetriken werden der ACS-Einheit 2 zur Ermittlung der optimalen Pfade ('Survivor Paths') zugeführt, wobei die 'Survivor Memory Unit' 4 diese 'Survivor Paths' speichert, so daß abschließend eine Decodierung anhand desjenigen 'Survivor Path' durchgeführt werden kann, der die beste Pfadmetrik aufweist. Die diesem Pfad zugeordnete Symbolsequenz entspricht mit der größten Wahrscheinlichkeit der tatsächlich gesendeten Sequenz.

Die ACS-Einheit 2 umfaßt mehrere Prozessorelemente, wobei in der Regel jeder Zustand des Trellis-Diagramms von einem separaten Prozessorelement ausgewertet wird. Die Aufgabe jedes einzelnen Prozessorelements besteht darin, aus zwei miteinander konkurrierenden Pfaden (den sogenannte "Competitor Paths"), die zu einem Zustand des Trellis-Diagramms führen, den Pfad (den sogenannten "Survivor Path") mit der besten, d.h. kleinsten Pfadmetrik, auszuwählen. Anschließend werden die gespeicherten Werte für den zu diesem Zustand führenden 'Survivor Path' und dessen Pfadmetrik aktualisiert.

Wie aus dem in Fig. 4 gezeigten Trellis-Diagramm ersichtlich ist, ist jeder Zustand s zu dem Zeitpunkt t+1 über einen oberen Zweig und einen unteren Zweig mit einem entsprechenden vorhergehenden Zustand verbunden. Zur Ermittlung des diesem Zustand s entsprechenden 'Survivor Path' muß somit die Pfadmetrik des über den oberen Zweig zu dem Zustand s führenden Pfads mit der Pfadmetrik des über den unteren Zweig zu dem Zustand s führenden Pfads verglichen werden, d.h. die Aufgabe jedes Prozessorelements besteht darin, zur Bestimmung des 'Survivor Path' mit der Pfadmetrik $\gamma_{t+1}^{(s)}$ entweder den über den vorhergehenden 'oberen' Zustand mit der Pfadmetrik $\gamma_t^{(u)}$ und den 'oberen' Zweig mit der Zweigmetrik $\lambda_t^{(u)}$ führenden Pfad, dessen Pfadmetrik der Summe $\gamma_t^{(u)} + \lambda_t^{(u)}$ entspricht, oder den über den 'unteren' Zustand mit der Pfadmetrik $\gamma_t^{(1)}$ und den 'unteren' Zweig mit der Zweigmetrik $\lambda_t^{(1)}$ führenden Pfad, dessen Pfadmetrik der Summe $\gamma_t^{(1)} + \lambda_t^{(1)}$ entspricht, auszuwählen.

Da jedes für einen Zustand s im Zeitschritt t berechnete Ergebnis $\gamma_t^{(s)}$ zugleich die Grundlage für die Berechnung einer Pfadmetrik für einen zeitlich nachfolgenden Zustand ist, ist die in Fig. 5 gezeigte Rückkopplung der ACS-Einheit 2 über den Speicher 3 erforderlich, wobei in dem Speicher 3 die berechneten Pfadmetriken gepuffert werden.

Die Struktur des Speichers 3 muß entsprechend der Struktur des jeweiligen Trellis-Diagramms ausgestaltet sein. Während jeder Symbolperiode muß eine der Anzahl der Zustände des Trellis-Diagramms entsprechende Anzahl an Pfadmetriken aus dem Speicher 3 ausgelesen und in den Speicher 3 geschrieben werden. Für jeden 'Butterfly' des Trellis-Diagramms werden zwei Zustände gleichzeitig verarbeitet, so daß zwei Ausgangspfadmetriken aus dem Speicher 3 ausgelesen und zwei daraus berechnete Pfadmetriken in den Speicher 3 geschrieben werden müssen.

Dadurch entsteht jedoch das Problem, daß die Pfadmetriken nicht überschrieben werden dürfen, ehe sie nicht ausgelesen worden sind.

Um dies deutlicher zumachen, ist in Fig. 6 ein weiteres Trellis-Diagramm mit acht Zuständen dargestellt. Das Trellis-Diagramm weist die bereits beschriebene Butterfly-Struktur auf, wobei ein beispielhafter Butterfly gestrichelt dargestellt ist und die Ausgangszustände $S_t$ Nr. 1 und 5 sowie die Zielzustände $S_{t+1}$ Nr. 2 und 3 umfaßt. Für die Berechnung der Pfadmetriken der Zielzustände Nr. 2 und 3 müssen somit zuerst die Pfadmetriken der Ausgangszustände Nr. 1 und 5 ausgelesen werden.

Diese Konkurrenzsituation zwischen dem Auslesevorgang und dem Schreibvorgang hat zu einer in der Literatur auch als 'Ping-Pong'-Implentierung bekannten Ausgestaltung des Speicher 3 geführt, wobei der Speicher 3 in zwei Speicherbänke unterteilt wird, von denen die eine ausschließlich für Lesevorgänge und die andere ausschließlich für Schreibvorgänge vorgesehen ist.

Mit Hilfe dieser Technik werden zwar unerwünschte Kollisionen zuverlässig vermieden. Der Speicher 3 muß jedoch die doppelte Größe als an sich erforderlich aufweisen, da beide Speicherbänke jeweils die Pfadmetriken sämtlicher Zustände $S_t$ bzw. $S_{t+1}$ speichern können müssen.

Ein weiteres mit dem Speichern der Pfadmetriken verbundenes Problem ist die als 'Mapping' bezeichnete Abbildung der Pfadmetriken auf den Speicher, d.h. die Zuordnung der einzelnen Pfadmetriken zu den unterschiedlichen Speicheradressen. Dieses 'Mapping' muß gemäß dem Stand der Technik so gewählt werden, daß für die Lese- und Schreibvorgänge der Pfadmetriken unterschiedliche Speicherbereiche verwendet werden, um Konflikte zwischen den Lese- und Schreibvorgängen zuverlässig zu vermeiden.

Der vorliegenden Erfindung liegt die Aufgabe zugrunde, ein Verfahren zum Speichern von Pfadmetriken in einem Viterbi-Decodierer vorzuschlagen, welches mit einem geringeren Speicherbedarf realisiert werden kann und zuverlässig Schreib/Lese-Konflikte verhindert.

Diese Aufgabe wird erfindungsgemäß durch ein Verfahren mit den Merkmalen des Anspruches 1 gelöst. Die Unteransprüche definieren vorteilhafte und bevorzugte Ausführungsformen der vorliegenden Erfindung.

Mit Hilfe der vorliegenden Erfindung wird ein Verfahren zum Speichern von Pfadmetriken in einem Viterbi-Decodierer vorgestellt, welches auf dem Prinzip eines zeitvarianten Trellis-Diagramms beruht und insbesondere für Trellis-Diagramme mit Butterfly-Struktur bzw. entsprechende. ACS-Einheiten geeigneten ist.

Das erfindungsgemäße Verfahren erfordert lediglich einen Speicher und ermöglicht das Auslesen und Speichern von Pfadmetriken aus bzw. in denselben Speicherbereichen, d.h. die auf Grundlage von zwei Ausgangspfadmetriken berechneten Pfadmetriken entsprechender Zielzustände werden unter derjenigen Speicheradresse gespeichert, aus der zuvor die beiden Ausgangspfadmetriken ausgelesen worden sind. Der Umfang des Speichers ist von dem jeweils gewählten Grad der Parallelität der Trellis unabhängig und muß lediglich dem Produkt aus der Anzahl der verschiedenen Trellis-Zustände und der Anzahl der Bits pro Speicherwort entsprechen. Insbesondere ist auch nur dann ein Speicher erforderlich, wenn die Pfadmetriken für mehrere Prozessorelemente zusammengefaßt gespeichert werden sollen.

Schreib-/Lese-Konflikte werden zuverlässig vermieden.

Die Erfindung erfordert einen minimalen Flächenbedarf und Leistungsverbrauch des zur Viterbi-Decodierung verwendeten Chips, da für zwei Pfadmetriken lediglich eine Speicheradresse erforderlich ist. Die Erfindung ist sowohl für Vorwärtscodes ('Feedforward Codes'), wie beispielsweise SDSL, als auch für Rückwärtscodes ('Feedback Codes') geeignet und ermöglicht die Verwendung von programmierbaren Viterbi-Decodierern, wobei für jeden 'Butterfly' die entsprechenden Pfadmetriken einfach programmiert werden können.

Die vorliegende Erfindung wird nachfolgend unter Bezugnahme auf die beigefügte Zeichnung näher anhand eines bevorzugten Ausführungsbeispiels erläutert.

Fig. 1 zeigt eine Darstellung zur Erläuterung des der vorliegenden Erfindung zugrundeliegenden Prinzips für einen SDSL-Viterbi-Decodierer auf Grundlage einer acht Zustände umfassenden Trellis,

Fig. 2 zeigt eine Darstellung zur Erläuterung einer Funktion, mit deren Hilfe abhängig von einem Zählerstand ein Zustand ermittelt werden kann, der gemäß einem bevorzugten Ausführungsbeispiel der Erfindung für die Abbildung der einzelnen Pfadmetriken auf die unterschiedlichen Speicheradressen des Speichers der ACS-Einheit maßgeblich ist,

Fig. 3 zeigt eine Darstellung zur Erläuterung eines Verfahrens, aus dem das erfindungsgemäße Verfahren als Weiterbildung hervorgeht,

Fig. 4 zeigt ein beispielhaftes Trellis-Diagramm mit Butterfly-Struktur und vier Zuständen,

Fig. 5 zeigt den allgemeinen Aufbau eines Viterbi-Decodierers, und

Fig. 6 zeigt die Darstellung eines Trellis-Diagramms mit Butterfly-Struktur zur Erläuterung der mit dem Stand der Technik verbundenen Probleme, und

Ehe auf die Einzelheiten der vorliegenden Erfindung näher eingegangen wird, soll nachfolgend kurz die Nomenklatur vorgestellt werden, auf die später zur Erläuterung der Erfindung zurückgegriffen wird.

Wird von einem Trellis-Codierer mit einem Gesamtspeicherumfang von $M_T$ Speicherwörtern ausgegangen, erhält man ein Trellis-Code mit $N_{TS} = 2^{M_T}$, wobei $N_{TS}$ die Anzahl der unterschiedlichen Zustände in dem entsprechenden Trellis-Diagramm bezeichnet. Die Länge der Impulsantwort für einen Vorwärtscode der Coderate $\frac{1}{2}$ beträgt $M_T+1$. Die Zustandsübergänge in dem Trellis-Diagramm hängen wie beschrieben von dem jeweils codierten Bit B ab, wobei sich der Zustand $S_{t+1}$ zum Zeitpunkt t+1 aus dem vorhergehenden Zustand $S_t$ gemäß folgender Beziehung ergibt:

$$S_{t+1} = \left(2 \cdot S_t\right) \bmod \left(N_{TS}\right) + B$$

Weist das Trellis-Diagramm die bereits beschriebene und beispielhaft in Fig. 6 gezeigte Butterfly-Struktur auf, sind jedem 'Butterfly' zwei Ausgangszustände und zwei Zielzustände zugewiesen, wobei jeweils unter Bezugnahme auf die Geometrie der Trellis zwischen einem mit dem Index (u) (für 'upper') bezeichneten oberen Zustand und einem mit dem Index (l) (für 'lower') bezeichneten unteren Zustand unterschieden werden kann. Bei dem in Fig. 6 gestrichelt gezeigten 'Butterfly' gilt beispielsweise $S_t^{(u)} = 1$, $S_t^{(l)} = 5$, $S_{t+1}^{(u)} = 2$ und $S_{t+1}^{(l)} = 3$, wobei $S_t^{(u)}$ und $S_t^{(l)}$ die Ausgangszustände und $S_{t+1}^{(u)}$ und $S_{t+1}^{(l)}$ die Zielzustände des entsprechenden 'Butterfly' bezeichnen.

Wie auch der Darstellung von Fig. 6 entnommen werden kann, hängen der untere Ausgangszustand $S_t^{(l)}$ sowie die Zielzustände

$S_{t+1}^{(u)}$ und $S_{t+1}^{(l)}$ eines 'Butterfly' von dem oberen Ausgangszustand $S_t^{(u)}$ ab, wobei die folgenden Beziehungen gelten:

$$0 \leq S_t^{(u)} \leq \frac{N_{TS}}{2} - 1$$

$$S_t^{(l)} = S_t^{(u)} + \frac{N_{TS}}{2}$$

$$S_{t+1}^{(u)} = \left(2 \cdot S_t^{(u)}\right) \bmod \left(N_{TS}\right) + 0$$

$$S_{t+1}^{(l)} = \left(2 \cdot S_t^{(u)}\right) \bmod \left(N_{TS}\right) + 1 = \left(2 \cdot S_t^{(l)}\right) \bmod \left(N_{TS}\right) + 1$$

Bei Auswertung der obigen Formeln mit $N_{TS} = 8$ und $S_t^{(u)} = 1$ ergeben sich für den in Fig. 6 gestrichelt dargestellten 'Butterfly' die korrekten Werte $S_t^{(l)} = 5$, $S_{t+1}^{(u)} = 2$ und $S_{t+1}^{(l)} = 3$.

Der vorliegenden Erfindung liegt die Idee zugrunde, die für die Zielzustände berechneten Pfadmetriken eines 'Butterfly' unter derselben Speicheradresse zu speichern, aus der die entsprechenden Ausgangspfadmetriken ausgelesen worden sind, so daß ein unerwünschtes Überschreiben der Pfadmetriken in dem Speicher 3 vermieden werden kann. Diese Maßnahme hat eine zeitabhängige Veränderung der Trellis-Struktur zur Folge, so daß die daraus resultierende Trellis-Darstellung auch als 'Time Varying Trellis' (TVT) bezeichnet werden kann.

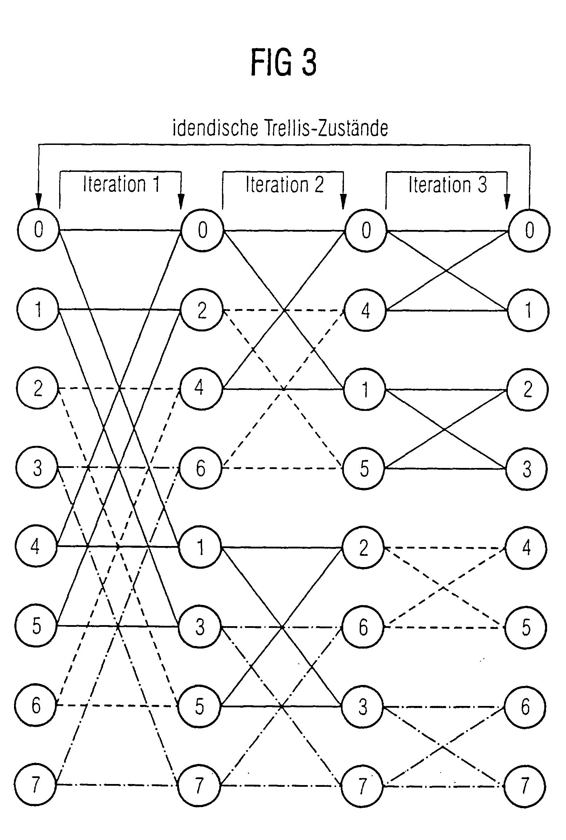

Die TVT der in Fig. 6 gezeigten Trellis-Struktur ist in Fig. 3 dargestellt. Wie aus Fig. 3 ersichtlich ist, stimmen die Zustandsübergänge der einzelnen 'Butterflies' zwar mit den in Fig. 6 gezeigten Zustandsübergängen überein, mit jedem Zeitschritt oder mit jeder Iteration ist jedoch die Folge der Zustände derart umgeordnet, daß jeder Zielzustand eines 'Butterfly' durch einen horizontalen Zweig mit dem entsprechenden Ausgangszustand desselben 'Butterfly' verbunden ist. In Fig. 3 sind für die einzelnen Iterationen zwei 'Butterflies', welche die Ausgangszustände Nr. 2 und Nr. 6 bzw. Nr. 3 und Nr. 7 sowie die Zielzustände Nr. 4 und Nr. 5 bzw. Nr. 6 und Nr. 7 umfassen, gestrichelt bzw. strichpunktiert dargestellt, so daß insbesondere anhand dieser 'Butterflies' das Prinzip der zeitabhängigen Umordnung der Trellis-Struktur nachvollzogen werden kann.

Jede Zeile der in Fig. 3 gezeigten Trellis entspricht einer Speicheradresse des Speichers 3, so daß beispielsweise in ein und dieselbe Speicheradresse nacheinander die Pfadmetriken für die Zustände Nr. 2, Nr. 4, Nr. 1 und Nr. 2 geschrieben werden (dritte Zeile in dem in Fig. 3 gezeigten Trellis-Diagramm). Es kann nachgewiesen werden, daß nach $M_T$ Iterationen (bei dem dargestellten Beispiel nach $M_T = 3$ Iterationen) wieder die ursprüngliche Zustandsfolge erhalten wird.

Der zuvor beschriebene TVT-Ansatz verhindert das unerwünschte Überschreiben von Pfadmetriken in dem Speicher 3. Es besteht jedoch weiterhin das Problem, daß zwei Pfadmetriken gleichzeitig gelesen und geschrieben werden müssen, um die auf der Butterfly-Struktur basierende Berechnung der Pfadmetriken durch die ACS-Einheit 2 zu ermöglichen, so daß der Speicher entsprechend unterteilt werden müßte. Es kann gezeigt werden, daß dies für den TVT-Ansatz jedoch nicht möglich ist.

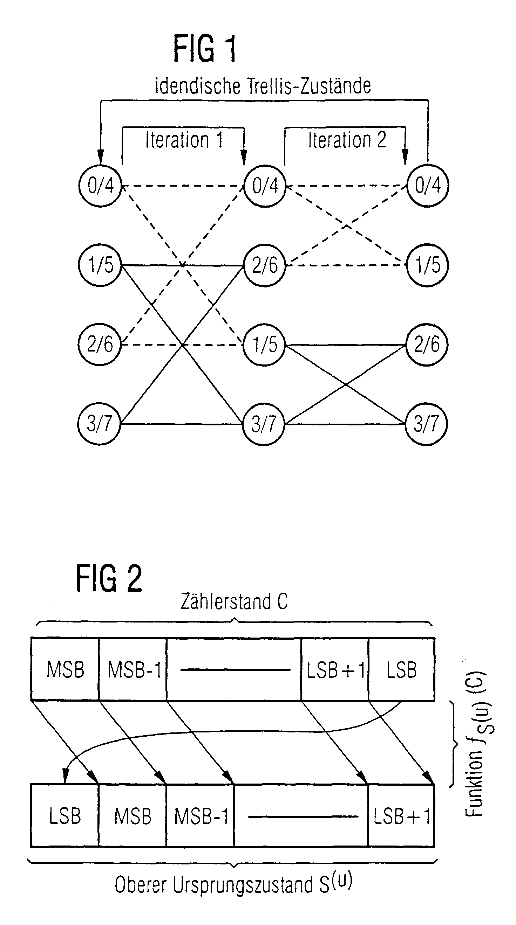

Der TVT-Ansatz muß daher zu einem der Butterfly-Struktur gerecht werdenden Ansatz weiter entwickelt werden, der nachfolgend anhand von Fig. 1 und Fig. 2 erläutert werden soll und auch als 'Butterfly Oriented Time Varying Trellis' (BFTVT) bezeichnet werden kann.

Das mit dem zuvor beschriebenen TVT-Ansatz im wesentlichen verbundene Problem besteht darin, daß die von der ACS-Einheit 2 berechneten Pfadmetriken der Zielzustände eines 'Butterfly' nicht zugleich Ausgangspfadmetriken für einen weiteren 'Butterfly' darstellen. Zur Verdeutlichung dieses Sachverhalts werden nachfolgend die Ausgangs- bzw. Zielpfadmetrikpaare eines 'Butterfly' in der Form $[S_t^{(u)}, S_t^{(l)}]$ bzw. $[S_{t+1}^{(u)}, S_{t+1}^{(l)}]$ dargestellt. Für die einzelnen 'Butterflies' der in Fig. 3 gezeigten Trellis (Iteration 1) ergeben sich somit folgende Zustandsübergänge:

$$[0,4] \rightarrow [0,1]$$
$$[1,5] \rightarrow [2,3]$$
$$[2,6] \rightarrow [4,5]$$
$$[3,7] \rightarrow [6,7]$$

Es ist ersichtlich, daß beispielsweise die Zielzustände [0,1] des 'Butterfly' mit den Ausgangszuständen [0,4] nicht gleichzeitig Ausgangszustände für einen gemeinsamen 'Butterfly' der Iteration 2 darstellen. Es macht daher keinen Sinn, die Ausgangs- und Zielpfadmetriken jedes 'Butterfly' in Form eines gemeinsamen Speicherworts zu speichern.

Andererseits ist jedoch offensichtlich, daß beispielsweise die Zielzustände [0,1] und [4,5] der beiden 'Butterflies', welche die Ausgangszustände [0,4] und [2,6] aufweisen, zugleich als Ausgangszustände für in dem Trellis-Diagramm nachfolgende 'Butterflies' mit den Ausgangszuständen [0,4] und [1,5] genutzt werden können. Es kann bewiesen werden, daß sämtliche $2^{M_T-1}$ 'Butterflies' paarweise derart zusammengefaßt werden können, daß die Pfadmetriken der Zielzustände der 'Butterfly'-Paare zugleich als Ausgangspfadmetriken für zwei andere 'Butterflies' genutzt werden können, wenn die für die Zielzustände ermittelten Pfadmetriken entsprechend umgeordnet werden.

Dieser Ansatz ist in Fig. 1 dargestellt. Die Wortbreite jedes Speicherworts des Speichers 3 wird gegenüber dem Stand der Technik verdoppelt, so daß die Ergebnisse bzw. Pfadmetriken der Zielzustände von zwei 'Butterflies' in Paaren von mindestens zwei Pfadmetriken pro Speicherwort gespeichert werden können. Insbesondere ist die Größe des Speichers von der Anzahl der verwendeten Prozessorelemente unabhängig, nur die Anzahl der Schreib-/Lesevorgänge ändert sich.

In Fig. 1 entspricht jeder Kreis den beiden Ausgangszuständen bzw. deren Ausgangspfadmetriken eines entsprechenden 'Butterfly' in der Form $S^{(u)}/S^{(l)}$. Durch das paarweise Zusammenfassen der einzelnen 'Butterflies' entsteht die in Fig. 1 gezeigte übergeordnete Butterfly-Trellis-Struktur, wobei durch die in Fig. 1 gezeigte Trellis festgelegt wird, welche Pfadmetriken der Zielzustände der paarweise zusammengefaßten ursprünglichen 'Butterflies' als Ausgangspfadmetriken für welche nachfolgenden 'Butterflies' verwendet werden. So ist in Fig. 1 beispielsweise ein gestrichelt dargestellter übergeordneter 'Butterfly' dargestellt, der wie beschrieben die ursprünglichen 'Butterflies' mit den Ausgangszuständen [0,4] bzw. [2,6] sowie den Zielzuständen [0,1] bzw. [4,5] zusammenfaßt und die daraus resultierenden Zielzustände in Paare zu [0,4] und [1,5] umordnet, so daß diese umgeordneten Zielzustandspaare zugleich als Ausgangszustände für nachfolgende 'Butterflies' dienen können (vgl. die Butterfly-Struktur von Fig. 6, woraus ersichtlich ist, daß die Ausgangszustände [0,4] und [1,5] jeweils einem 'Butterfly' zugeordnet sind).

Des weiteren ist die somit erhaltene übergeordnete Trellis-Struktur analog zu Fig. 3 in Form einer TVT-Struktur aufgebaut. Jede Zeile der in Fig. 1 gezeigten Trellis entspricht somit einer Speicheradresse des Speichers 3, so daß beispielsweise hinsichtlich der zweiten Zeile der dargestellten Trellis die Pfadmetriken der Zustandspaare [1,5], [2,6] und wieder [1,5] nacheinander unter ein und derselben Speicheradresse gespeichert werden.

Wie der Darstellung von Fig. 1 entnommen werden kann, reduziert sich die Dimension der Trellis aufgrund des paarweise Zusammenfassens der einzelnen 'Butterflies' gegenüber Fig. 3 auf $2^{M_T-1}$ Zustände, so daß sich entsprechend auch die Anzahl der Iterationen, welche bis zur Wiedergewinnung der ursprünglichen Zustandsfolge erforderlich sind, gegenüber Fig. 3 um den Wert 1 verringert. Dies hat zur Folge, daß auch der Adressierungsaufwand hinsichtlich der Adressengenerierung für den Speicher 3 entsprechend reduziert werden kann.

Es wurde zuvor darauf hingewiesen, daß sämtliche Zustände eines 'Butterfly' aus dem oberen Ausgangszustand $S^{(u)}$ dieses 'Butterfly' abgeleitet werden können. Die jeweils geeignete Speicheradresse für die in Fig. 1 gezeigten Pfadmetrikpaare kann somit relativ einfach dadurch ermittelt werden, daß ein Zähler verwendet wird, dessen Zählerstand C zwischen

$$\left[ 0 \ldots \frac{N_{TS}}{2} - 1 \right]$$

variiert, wobei mit Hilfe einer Funktion $f_{S^{(u)}}(C)$ davon abhängig der dem augenblicklichen Zählerstand C jeweils entsprechende obere Zustand $S^{(u)}$ des 'Butterfly'-Paars ermittelt und anschließend mit Hilfe einer Adressierungsfunktion $f_{addr}(S^{(u)}, I)$ abhängig von dem ermittelten oberen Zustand $S^{(u)}$ und der jeweils aktuellen Iterationszahl I die geeignete Speicheradresse bestimmt wird. Für den Fall, daß die Pfadmetriken mehrerer Prozessorelemente zusammengefaßt werden sollen, muß der Zählerstand des Zählers zwischen

$$\left[ 0 \ldots \frac{N_{TS}}{2^{ld(N_{PE})}} - 1 \right]$$

variieren, wobei $N_{PE}$ der Anzahl der Prozessorelemente entspricht und ld(X) dem Ausdruck $\log_2(X)$ entspricht.

Die Funktion $f_{S(u)}(C)$ ist nicht-linear. Es kann gezeigt werden, daß diese Funktion in Form einer einfachen Bitabbildung, wie sie in Fig. 2 gezeigt ist, realisiert werden kann, wobei MSB das höherwertigste Bit ('Most Significant Bit') und LSB das niederwertigste Bit ('Least Significant Bit') bezeichnet.

Die Adressierungsfunktion $f_{addr}(S^{(u)},I)$ kann aufgrund der Eigenschaften eines Vorwärts-Trellis-Codieres durch folgende Beziehung beschrieben werden:

$$ADDR = \left[ \left( 2^I \cdot S^{(u)} \right) \bmod \left( M_T - 1 \right) \right] + \left[ 2^{(I-M_T+1)} \cdot S^{(u)} \right]$$

Dabei bezeichnet ADDR die in Abhängigkeit von $S^{(u)}$, $M_T$ und I bestimmte Speicheradresse für das jeweilige Pfadmetrikpaar mit $I \in [0 \ldots M_T-1]$. Diese Adressierungsfunktion läßt sich leicht implementieren, da sie lediglich einer $(M_T-1)$-Bitaddition des dargestellten ersten und zweiten Terms entspricht, ohne daß auf einen möglichen Überlauf geachtet werden muß. Alle Multiplikationen innerhalb der dargestellten Formel können durch einfache Bitverschiebeoperationen realisiert werden.

Für den Fall, daß die Erfindung auf mehrere Prozessorelemente angewendet werden soll, kann die Adressierungsfunktion $f_{addr}(S^{(u)},I)$ durch folgende Beziehung beschrieben werden:

$$ADDR = \left[ \left( 2^I \cdot S^{(u)} \right) \bmod \left( 2^{(ld(N_{TS}) - ld(N_{PE}) - 1)} \right) \right] + \left[ 2^{(ld(N_{TS}) - I - ld(N_{PE}) - 1)} \cdot S^{(u)} \right]$$

Die Erfindung wurde zuvor anhand der Verwendung von Vorwärtscodes, beispielsweise eines SDSL-Codes, erläutert. Die Erfindung ist jedoch ebenso auf Rückwärtscodes anwendbar. Die Trellis-Struktur eines Viterbi-Decodierers für Rückwärtscodes unterscheidet sich zwar beträchtlich von derjenigen für Vorwärtscodes. Auch für Rückwärtscodes können jedoch in der Trellis 'Butterflies' paarweise derart zusammengefaßt werden, daß die entsprechenden Pfadmetriken der Zielzustände zugleich Ausgangspfadmetriken für zwei in dem Trellis-Diagramm nachfolgende 'Butterflies' darstellen. Im Gegensatz zu Vorwärtscodes hängt die Anzahl der Iterationen, welche erforderlich sind, bis in dem Trellis-Diagramm wieder die ursprüngliche Zustandsfolge auftritt, nicht direkt von dem Wert $M_T$ ab. Auch für Rückwärtscodes können analog zu der für Vorwärtscodes zuvor beschriebenen Vorgehensweise entsprechende Ausdrücke für $f_{S(u)}(C)$ und $f_{addr}(S^{(u)},I)$ ermittelt werden, auf deren Herleitung jedoch an dieser Stelle verzichtet wird.

**Patentansprüche**

1. Verfahren zum Speichern von Pfadmetriken in einem Viterbi-Decodierer,

   wobei die Pfadmetriken anhand eines dem Viterbi-Decodierer zugewiesenen Trellis-Diagramms bestimmt werden, in dem jeweils zwei Zielzustände eines bestimmten Zeitschritts (t+1) mit zwei Ausgangszuständen eines vorhergehenden Zeitschritts (t) eine Butterfly-Struktur bilden, durch welche die entsprechenden beiden Zielzustände des bestimmten Zeitschritts (t+1) durch jeweils einen Zustandsübergangszweig mit den beiden Ausgangszuständen des vorhergehenden Zeitschritts (t) verbunden sind,

   wobei für jeden Zeitschritt (t+1) die Pfadmetrik ($\gamma_{t+1}$) jedes Zielzustands abhängig von den Pfadmetriken ($\gamma_t$) derjenigen Ausgangszustände des vorhergehenden Zeitschritts (t), die mit dem jeweiligen Zielzustand eine Butterfly-Struktur bilden, bestimmt werden, wobei hierzu die Pfadmetriken ($\gamma_t$) der entsprechenden beiden Ausgangszustände aus Speichermitteln (3) ausgelesen, davon abhängig die Pfadmetrik ($\gamma_{t+1}$) des jeweiligen

Zielzustands des Zeitschritts (t+1) bestimmt und die Pfadmetrik ($\gamma_{t+1}$) des jeweiligen Zielzustands in den Speichermitteln (3) gespeichert wird,

**dadurch gekennzeichnet,**

daß die Butterfly-Strukturen des Trellis-Diagramms jedes Zeitschritts (t) derart mindestens paarweise zusammengefaßt werden, daß für jedes Butterfly-Strukturenpaar eines Zeitschritts (t) die Zielzustände der beiden Butterfly-Strukturen in dem Trellis-Diagramm zugleich Ausgangszustände für zwei Butterfly-Strukturen des nachfolgenden Zeitschritts (t+1) bilden, und

daß nach der Bestimmung der Pfadmetriken der Zielzustände der beiden Butterfly-Strukturen eines Butterfly-Strukturenpaars jeweils die Pfadmetriken derjenigen beiden Zielzustände dieses Butterfly-Strukturenpaares, die zugleich Ausgangszustände einer Butterfly-Struktur eines nachfolgenden Zeitschritts (t+1) bilden, in den Speichermitteln (3) in Form eines gemeinsamen Speicherworts gespeichert werden.

2.  Verfahren nach Anspruch 1,
    **dadurch gekennzeichnet,**

    daß jeweils die Pfadmetriken derjenigen beiden Ausgangszustände eines Zeitschritts (t), die zu derselben Butterfly-Struktur gehören, in Form eines gemeinsamen Speicherworts in den Speichermitteln (3) gespeichert werden, und

    daß nach der Bestimmung der Pfadmetriken der Zielzustände der beiden Butterfly-Strukturen eines Butterfly-Strukturenpaars jeweils die Pfadmetriken derjenigen beiden Zielzustände dieses Butterfly-Strukturenpaares, die zugleich die Ausgangszustände einer Butterfly-Struktur des nachfolgenden Zeitschritts (t+1) bilden, in den Speichermitteln (3) unter derselben Adresse wie die Pfadmetriken von zwei Ausgangszuständen, die mit einem dieser beiden Zielzustände eine Butterfly-Struktur bilden, gespeichert werden.

3.  Verfahren nach Anspruch 1 oder 2,
    **dadurch gekennzeichnet,**
    daß die Pfadmetrik ($\gamma_{t+1}$) jedes Zielzustands abhängig von den Pfadmetriken ($\gamma_t$) der beiden Ausgangszustände der entsprechenden Butterfly-Struktur sowie von Zweigmetriken ($\lambda_t$), die den beiden Zustandsübergangszweigen der Butterfly-Struktur zugewiesen sind, bestimmt werden.

4.  Verfahren nach Anspruch 3,
    **dadurch gekennzeichnet,**
    daß in jeder Butterfly-Struktur eine erste Zweigmetrik für den den ersten Ausgangszustand mit dem ersten Zielzustand verbindenden Zustandsübergangszweig und den den zweiten Ausgangszustand mit dem zweiten Zielzustand verbindenden Zustandsübergangszweig gleich groß ist sowie eine zweite Zweigmetrik für den den ersten Ausgangszustand mit dem zweiten Zielzustand verbindenden Zustandsübergangszweig und den zweiten Ausgangszustand mit dem ersten Zielzustand verbindenden Zustandsübergangszweig gleich groß ist.

5.  Verfahren nach einem der vorhergehenden Ansprüche,
    **dadurch gekennzeichnet,**
    daß das Verfahren zur Decodierung eines mit einem Vorwärtscode codierten Signals angewendet wird.

6.  Verfahren nach Anspruch 5,
    **dadurch gekennzeichnet,**
    daß das Verfahren zur Decodierung eines SDSL-codierten Signals angewendet wird.

7.  Verfahren nach einem der Ansprüche 1-4,
    **dadurch gekennzeichnet,**
    daß das Verfahren zur Decodierung eines mit einem Rückwärtscode codierten Signals angewendet wird.

# FIG 1

idendische Trellis-Zustände

Iteration 1    Iteration 2

# FIG 2

Zählerstand C

Funktion $f_{S^{(u)}}(C)$

Oberer Ursprungszustand $S^{(u)}$

# FIG 3

idendische Trellis-Zustände

Iteration 1    Iteration 2    Iteration 3

## FIG 4

EP 1 130 788 A2

## FIG 5

## FIG 6